# EUROPEAN PATENT APPLICATION

(11) **EP 4 597 523 A1**
(43) Date of publication of application: **06.08.2025**
(21) Application number: 23885451.7
(22) Date of filing: 05.10.2023
(51) Int. Cl.: H01B 5/14, G06F 3/041, G06F 3/044

(54) **CONDUCTIVE FILM**

(30) Priority: 02.11.2022 JP 2022176430
(71) Applicant: Panasonic Intellectual Property Management Co., Ltd., Kadoma-shi, Osaka 571-0057 (JP)
(72) Inventor: OKADA Momoko, Kadoma-shi, Osaka 571-8506 (JP); MURATA Keishiro, Kadoma-shi, Osaka 571-8506 (JP); SAKAUE Yoshitaka, Kadoma-shi, Osaka 571-8506 (JP)
(74) Representative: Grünecker Patent- und Rechtsanwälte PartG mbB
(86) International application number: PCT/JP2023/036339
(87) International publication number: WO 2024/095688

(57) **Abstract**

A first surface (5a) of a substrate (5) has a groove (9a) and a groove (9b) extending linearly. A thickness (L1) is smaller than a thickness (L2), where the angle (C1) between the bottom (91a) and the side surface (92a) of the groove (9a) is smaller than the angle (C2) between the bottom (91b) and the side surface (92b) of the groove (9b). The thickness (L1) is the thickness of the side surface (312a) of an adhesion layer (31a) extending in the side surface (92a) of the groove (9a). The thickness (L2) is the thickness of the side surface (312b) of an adhesion layer (31b) extending in the side surface (92b) of the groove (9b).

## Description

### TECHNICAL FIELD

The present disclosure relates to a conductive film.

### BACKGROUND ART

A touch sensor, such as one disclosed in Patent Document 1, using a conductive film is typically known.

Patent Document 1 discloses a touch sensor with a view area (i.e., a display area for displaying an image). This touch sensor includes a light-transmissive cover member (i.e., a polarizer), a substrate with a surface facing the back surface of the cover member, and a plurality of electrodes (i.e., touch electrodes) on the surface of the substrate in the view area.

The substrate has a plurality of bottomed grooves (grooves for forming conductive layers and lines) on its surface. Each electrode includes a plurality of fine lines in a predetermined pattern (e.g., a mesh pattern) on the surface of the substrate. Each fine line is a conductive layer with a metal material with an excellent conductivity buried in one of the grooves. The outer surface of the conductive layer faces the cover member (i.e., the polarizer) and is formed as a flat surface flush with the surface of the substrate.

### CITATION LIST

### PATENT DOCUMENT

Patent Document 1: WO 2021/131319A1

### SUMMARY

### TECHNICAL PROBLEMS

In the conductive film of Patent Document 1, each fine line includes a conductive layer and an adhesion layer. The conductive layer is embedded in a groove with an adhesion layer interposed therebetween. The adhesion layer is in the shape of a thin film on the groove. This adhesion layer ensures the adhesion of the conductive layer to the groove.

However, for example, when electricity flows into the conductive layer, heat is applied to the conductive layer and the adhesion layer, which may increase the temperatures in the conductive layer and the adhesion layer. If the conductive layer is made of a metal and the adhesion layer is made of a metal compound and the temperatures in the conductive layer and the adhesion layer rise, the conductive layer expands more, that is, has a larger volume than the adhesion layer. Accordingly, the expanding conductive layer presses the adhesion layer. In particular, if the groove is recessed and bottomed, both the side surfaces of the groove face each other, the conductive layer presses the adhesion layer extending along the side surfaces of the groove.

In addition, if the adhesion layer is made of a metal compound, the larger the film thickness of the adhesion layer, the higher the rigidity of the adhesion layer and the more stress against the expansion of the conductive layer is likely to occur inside the conductive layer, which leads to a damage of the adhesion layer.

The present disclosure was made in view of the problems. It is an object of the present disclosure to provide a conductive film resistant to disturbance, such as a temperature change or erosion.

### SOLUTION TO THE PROBLEMS

To achieve the object, a conductive film according to an embodiment of the present disclosure includes: a substrate with a first surface; and the first surface of the substrate including a first groove and a second groove that are bottomed and extend linearly. A first conductive layer made of a metal is embedded in the first groove with a first metal compound layer interposed therebetween. The first metal compound layer is made of a metal compound. A second conductive layer made of a metal is embedded in the second groove with a second metal compound layer interposed therebetween. The second metal compound layer is made of a metal compound. The first groove includes a first bottom, and a first side connecting the first bottom and an opening of the first groove. The second groove includes a second bottom, and a second side connecting the second bottom and an opening of the second groove. The first metal compound layer includes a first layer along the first side. The second metal compound layer includes a second layer along the second side. A first thickness is smaller than a second thickness, where a first angle between the first bottom and the first side is smaller than a second angle between the second bottom and the second side. The first thickness is a thickness of the first layer. The second thickness is a thickness of the second layer.

### ADVANTAGES OF THE INVENTION

The present disclosure can provide a conductive film resistant to disturbance, such as a temperature change or erosion.

### BRIEF DESCRIPTION OF DRAWINGS

FIG. 1 is an overall perspective view of a touch sensor according to an embodiment of the present disclosure.
FIG. 2 is a plan view schematically showing a connection between a substrate and a flexible wiring board.
FIG. 3 is a perspective view schematically showing respective configurations of the substrate, first electrodes, second electrodes, first leads, and second leads as viewed from a first surface of the substrate.
FIG. 4 is a plan view showing respective configurations of the substrate, the first electrodes, and the first leads as viewed from the first surface of the substrate.
FIG. 5 is a bottom view showing respective configurations of the substrate, the second electrodes, and the second leads as viewed from a second surface of the substrate.
FIG. 6 is a cross-sectional view taken along line VI-VI of FIG. 1.
FIG. 7 is a partially enlarged plan view showing an enlarged part of each first electrode.
FIG. 8 is a cross-sectional view taken along line VIII-VIII of FIG. 1.
FIG. 9 is a partially enlarged plan view showing an enlarged part of each first lead.
FIG. 10 is a partially enlarged plan view showing an enlarged part of a connecting pad.
FIG. 11 is a cross-sectional view schematically showing a cross section of each fine line of a first electrode and a second electrode.
FIG. 12 is a cross-sectional view schematically showing a cross section of each fine line of a first lead, a second lead, and a connection pad.
FIG. 13 is a cross-sectional view schematically showing a cross section of the groove shown in FIG. 11.
FIG. 14 is a cross-sectional view schematically showing a cross section of the groove shown in FIG. 12.

### DESCRIPTION OF EMBODIMENT

An embodiment of the present disclosure will be described below with reference to the drawings. Note that the following description of the embodiment is merely an example in nature, and is not intended to limit the scope, applications, or use of the present disclosure.

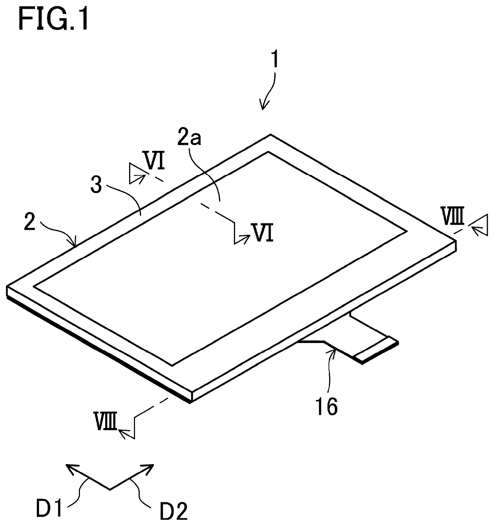

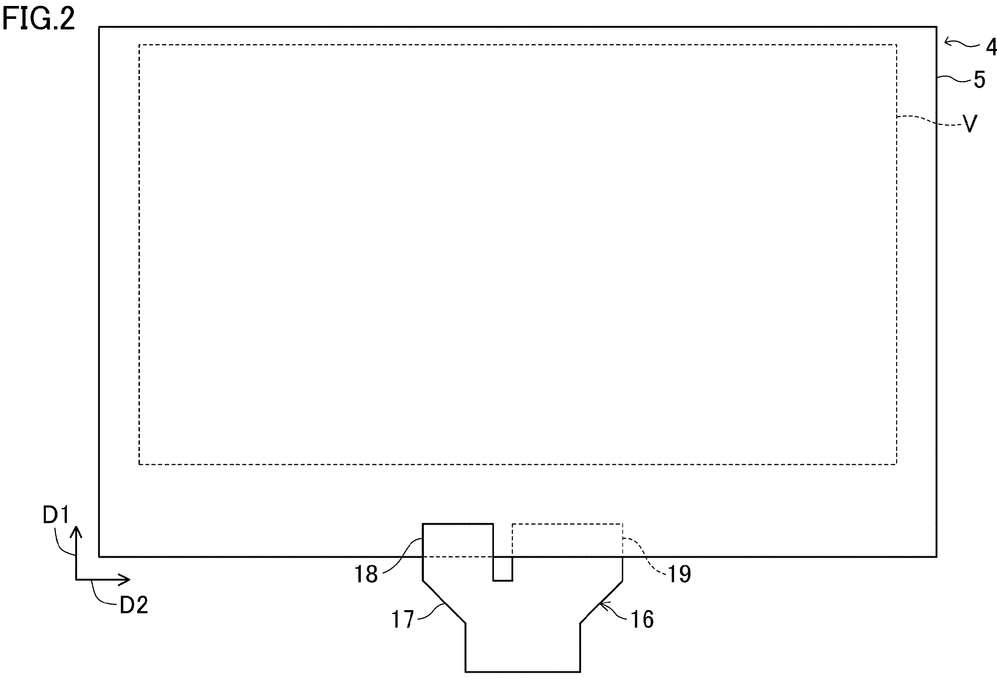

FIG. 1 shows the configuration of a touch sensor 1 to which a conductive film 4 (see FIGS. 2 to 5) according to an embodiment of the present disclosure is applied. The touch sensor 1 is a sensor input device on which a touch operation can be performed. The touch sensor 1 is used as an input device for, for example, an on-vehicle device such as a car navigation system, a display device of a personal computer, a mobile phone, a portable information terminal, a portable game machine, a copying machine, a ticket vending machine, an automatic teller machine, or a clock.

In the following description, an operation screen 2a of a cover member 2, which will be described later, is located on a "front side" of the touch sensor 1, whereas the opposite side thereof will be referred to as a "back side" of the touch sensor 1. With these terms, a positional relationship between elements forming the touch sensor 1 will be defined. In this embodiment, for the sake of simplicity, a first direction d1 extends from the bottom to the top on each paper of FIGS. 1 to 5, whereas a second direction d2 extends from the left to the right on each paper of FIGS. 1 to 5.

### (Cover Member)

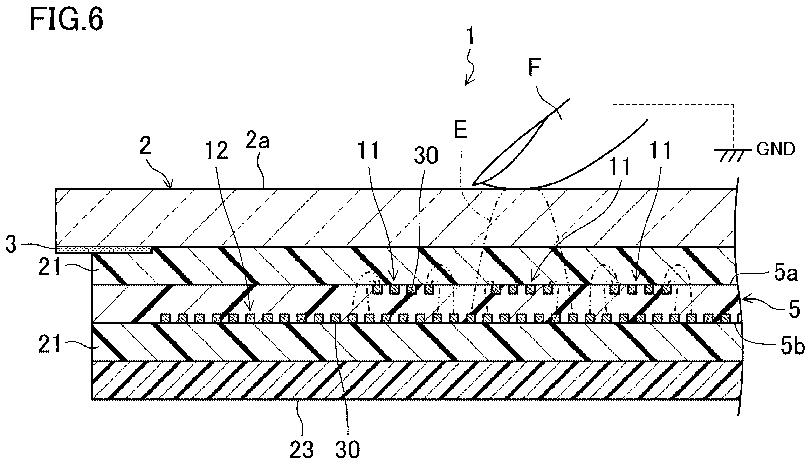

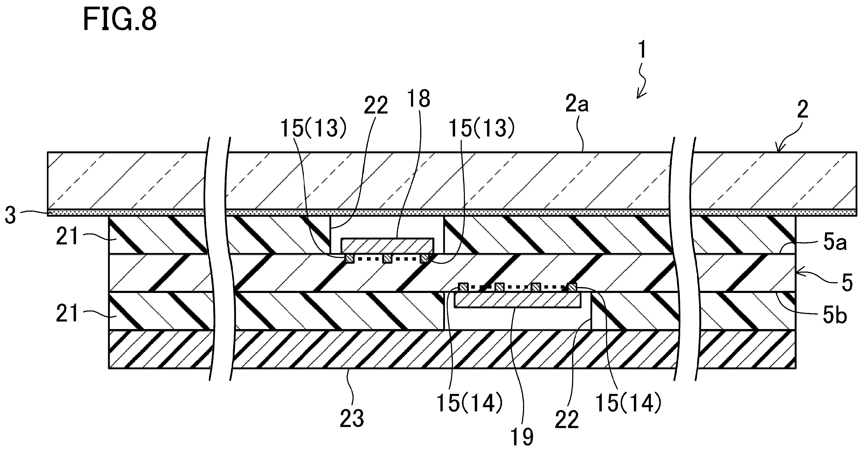

As shown in FIG. 1, the touch sensor 1 includes the cover member 2 having light-transmissive properties. The cover member 2 is a cover lens made of, for example, cover glass or plastic. The cover member 2 is in the shape of a rectangular plate, for example, in a plan view. The cover member 2 is fixed to a first surface 5a of a substrate 5, which will be described later, by an adhesive layer 21, which will be described later (see FIGS. 6 and 8).

As shown in FIGS. 1, 6, and 8, on the peripheral edge of the back surface of the cover member 2, a fringe 3 is formed substantially in a frame shape in a dark color such as black by screen printing, for example. The internal rectangular region surrounded by this fringe 3 serves as a light-transmittable view area V. That is, the user obtains visual information from a display panel (not shown) on the back side of the touch sensor 1 through the view area V. The surface of the cover member 2 in the view area V serves as the operation screen 2a touched by a user's finger F (see FIG. 6) in accordance with a touch operation.

### (Substrate)

As shown in FIGS. 2 to 5, the touch sensor 1 includes the substrate 5. The substrate 5 is substantially in a rectangular shape in a plan view. As shown in FIGS. 6 and 8, the substrate 5 has the first surface 5a and a second surface 5b. The substrate 5 is obtained by stacking the first surface 5a facing the back surface of the cover member 2 with the adhesive layer 21, which will be described later, interposed therebetween. In FIGS. 6 and 8, first and second groove forming layers 7 and 8, which will be described later, are not shown for the sake of simplicity.

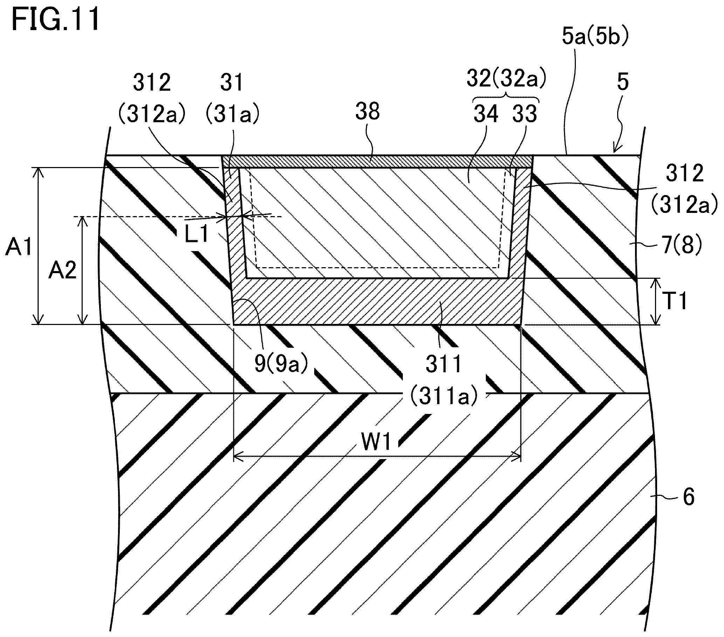

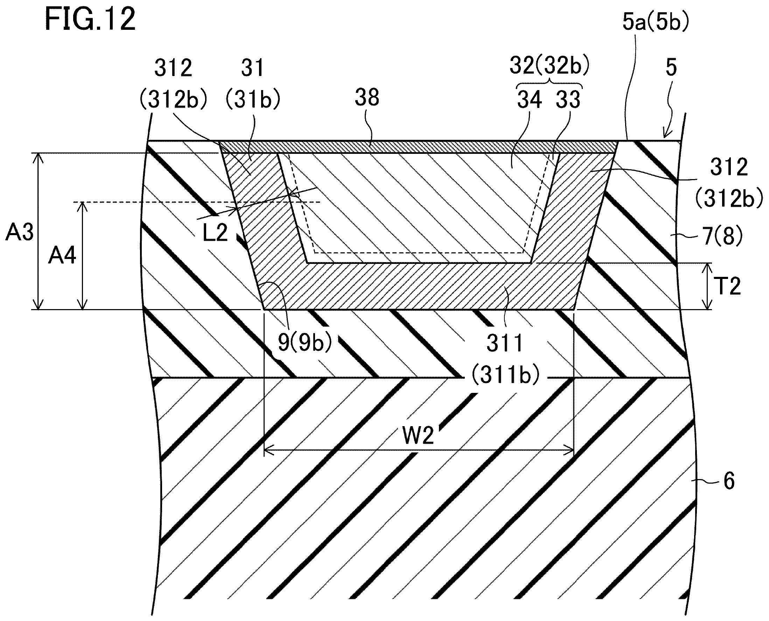

As shown in FIGS. 11 and 12, the substrate 5 has a film base 6. The film base 6 is made of a transparent resin material. Examples of the transparent resin material include resin materials such as polyethylene terephthalate (PET), polycarbonate, cycloolefin polymer (COP), and cycloolefin copolymer (COC).

The substrate 5 includes the first groove forming layer 7 and the second groove forming layer 8. The first and second groove forming layers 7 and 8 are for forming grooves 9, 9, . . . , which will be described later, and made of an insulating and transparent resin material.

The first groove forming layer 7 is stacked on the front side of the film base 6. The surface of the first groove forming layer 7 faces the back surface of the cover member 2. That is, the front surface of the first groove forming layer 7 corresponds to the first surface 5a of the substrate 5. The first groove forming layer 7 has a thickness ranging from 1.8 µm to 4.2 µm, for example.

The second groove forming layer 8 is stacked on the back side of the film base 6. The back surface of the second groove forming layer 8 faces the back surface of the cover member 2 with the first groove forming layer 7 and the film base 6 interposed therebetween. That is, the back surface of the second groove forming layer 8 corresponds to the second surface 5b of the substrate 5. The second groove forming layer 8 has a thickness ranging from 1.8 µm to 4.2 µm, for example.

As shown in FIGS. 11 and 12, each of the first surface 5a and the second surface 5b of the substrate 5 has the plurality of grooves 9, 9, . . . . The grooves 9 linearly extend to form a predetermined pattern, which will be described later, on each of the first surface 5a and the second surface 5b.

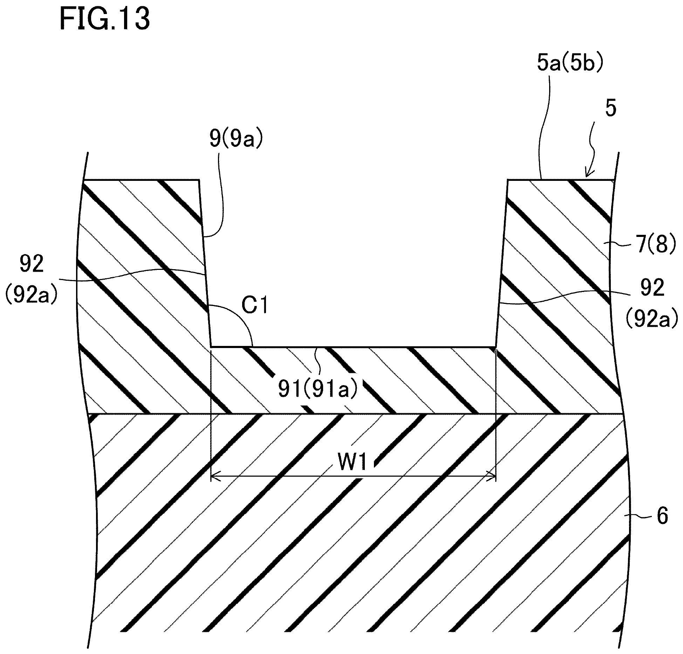

Each groove 9 on the first surface 5a is formed, in the first groove forming layer 7, in a bottomed shape recessed from the first surface 5a toward the front surface of the film base 6 (see FIG. 13). Each groove 9 on the second surface 5b is formed, in the second groove forming layer 8, in a bottomed shape recessed from the second surface 5b toward the back surface of the film base 6. Each groove 9 has a depth set in a range from 0.5 µm to 3.0 µm, for example.

### (Adhesive Layer)

As shown in FIGS. 6 and 8, the touch sensor 1 includes the adhesive layers 21 and 21. Each adhesive layer 21 is stacked on one of the first surface 5a and the second surface 5b of the substrate 5. The adhesive layer 21 is made of a transparent optical clear adhesive (OCA) with a thickness ranging from 25 µm to 250 µm in one preferred embodiment.

Each adhesive layer 21 is partially cut out into a cutout 22. Specifically, the adhesive layer 21 on the first surface 5a has the cutout 22 corresponding to the mount for a first connector 18, which will be described later, on the first surface 5a. The adhesive layer 21 on the second surface 5b has the cutout 22 corresponding to the mount for a second connector 19, which will be described later, on the second surface 5b.

### (First and Second Electrodes)

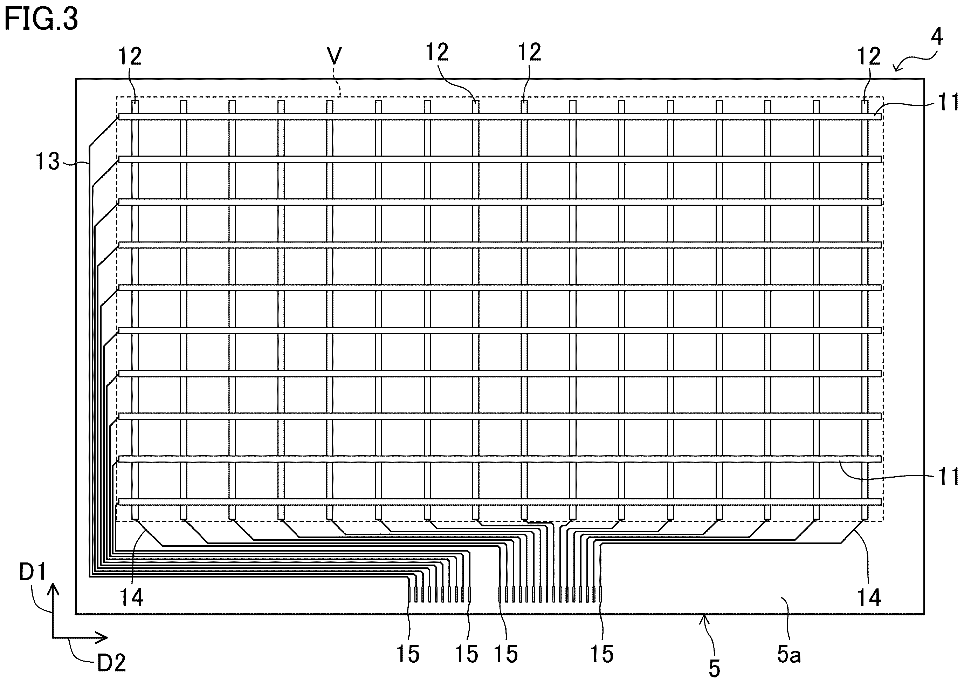

As shown in FIGS. 3 to 6, the touch sensor 1 includes a plurality of first electrodes 11, 11, ... and a plurality of second electrodes 12, 12, . . . of a capacitance type.

The first electrodes 11, 11, . . . and the second electrodes 12, 12, . . . are arranged in the view area V. The touch sensor 1 can detect a touch operation by the user's finger F (i.e., a detection target connected to the ground (GND)) touching the operation screen 2a of the cover member 2 through the first electrodes 11, 11, . . . and the second electrodes 12, 12, . . . in the view area V (see FIG. 6).

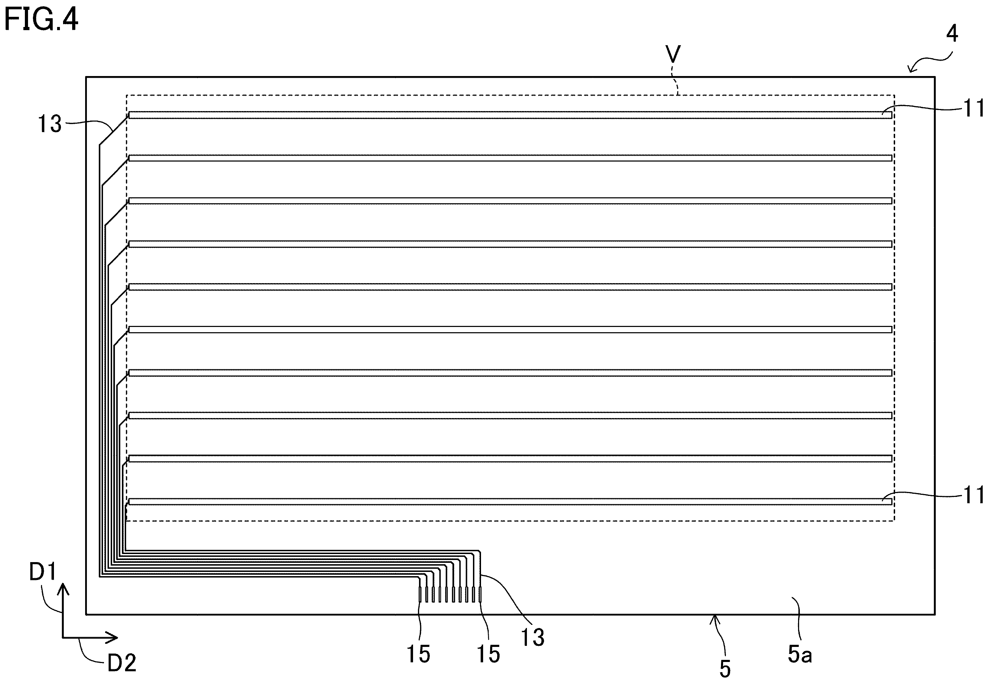

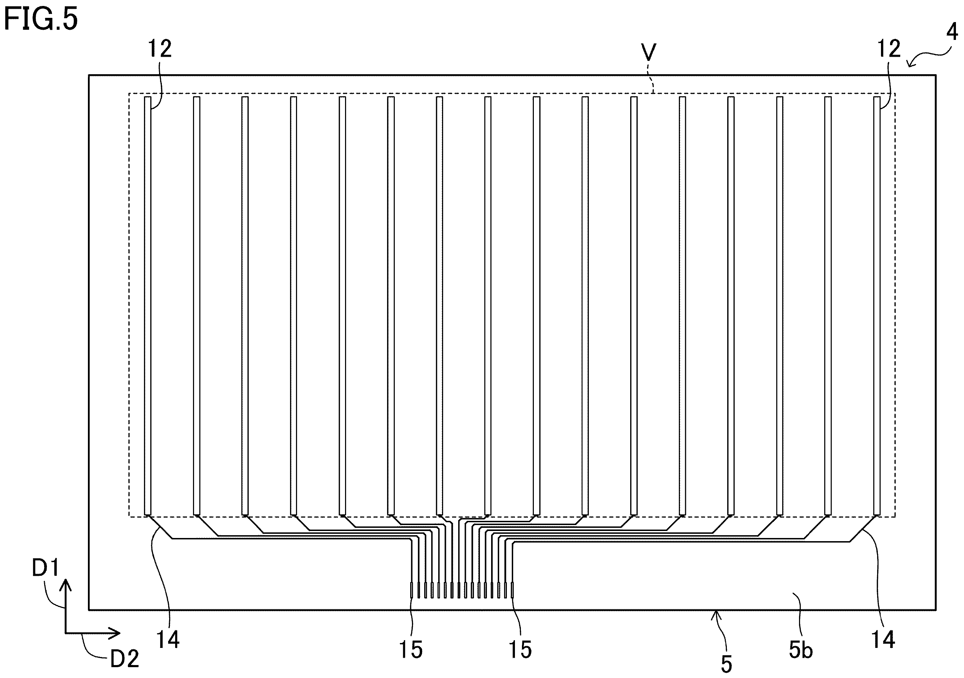

As shown in FIG. 4, each first electrode 11 is located on the first surface 5a of the substrate 5. On the other hand, as shown in FIG. 5, each second electrode 12 is located on the second surface 5b of the substrate 5. That is, the second electrodes 12 are insulated from the first electrodes 11 via the substrate 5.

As shown in FIG. 6, the first electrodes 11 receive an electric field E (see the two-dot chain line in FIG. 6) emitted from the second electrodes 12. That is, each first electrode 11 serves as a receiver electrode.

As shown in FIGS. 3 and 4, each first electrode 11 extends substantially in a band shape along the longer sides (i.e., in the second direction d2) of the substrate 5 in a plan view. The first electrodes 11, 11, . . . are arranged at intervals along the shorter sides (i.e., in the first direction d1) of the substrate 5. Each first electrode 11 is connected to a detection circuit (not shown) via a flexible wiring board 16 which will be described later.

As shown in FIG. 6, each second electrode 12 is connected to a drive circuit (not shown) via the flexible wiring board 16, which will be described later. This drive circuit emits the electric field E to the periphery. That is, each second electrode 12 serves as a transmitter electrode.

As shown in FIGS. 3 and 5, each second electrode 12 extends substantially in a band shape along the shorter sides (i.e., in the first direction d1) of the substrate 5 in a plan view. The second electrodes 12, 12, . . . are arranged at intervals along longer sides (i.e., in the second direction d2) of the substrate 5.

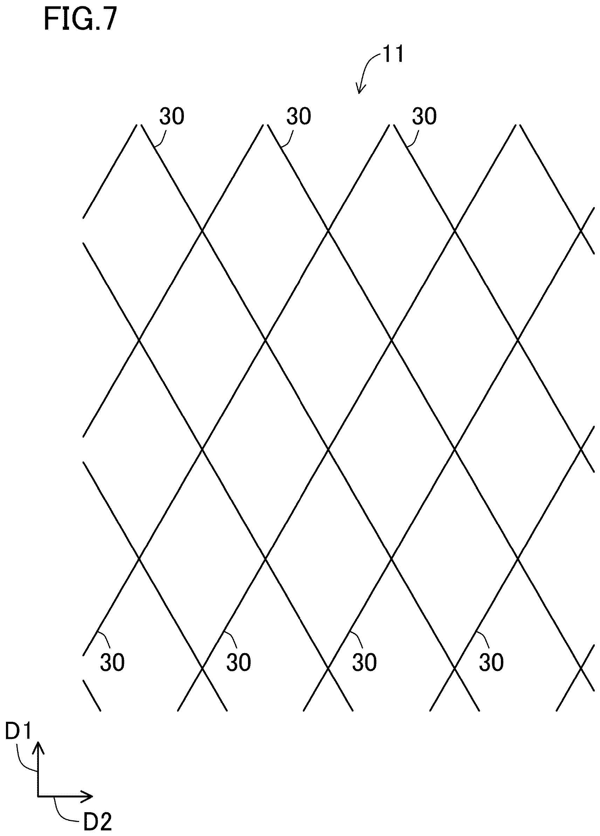

Each of the first electrodes 11 and the second electrodes 12 includes a plurality of fine lines 30, 30, . . . . Specifically, each of the first electrodes 11 and the second electrodes 12 is obtained by arranging the fine lines 30, 30, . . . in a predetermined pattern on one of the first surface 5a and the second surface 5b of the substrate 5. Examples of the predetermined pattern includes a first pattern (i.e., a mesh) obtained by arranging the fine lines 30, 30, . . . in a mesh (see FIG. 7).

As shown in FIG. 7, the first pattern includes the fine lines 30, 30, . . . intersecting each other and arranged at predetermined intervals (e.g., at an equal interval in the shown example) into the mesh. That is, the first pattern is a network structure obtained by regularly arranging a plurality of cells which are the fine lines 30, 30, . . . . The cells are in the shape of a parallelogram in the same size.

Each fine line 30 forming the first pattern extends obliquely from both the first direction d1 and the second direction d2. Each fine line 30 has a width of several micrometers, for example. Specifically, each of the first electrodes 11 and the second electrodes 12 includes the fine lines 30 with a line width set to 2 µm or less in order to ensure the visibility of the view area V in one preferred embodiment. A specific configuration of each fine line 30 will be described later.

Here, the predetermined pattern is not limited to the first pattern (i.e., the mesh), and may be, for example, a second pattern obtained by arranging the plurality of fine lines 30, 30, . . . in a ladder, or a third pattern obtained by arranging the plurality of fine lines 30, 30, . . . in a shape other than the mesh or the ladder.

### (First and Second Leads)

As shown in FIGS. 3 to 5, the touch sensor 1 includes a plurality of first leads 13, 13, ... and a plurality of second leads 14, 14, . . . . The first leads 13, 13, . . . and the second leads 14, 14, . . . are elements for electrically connecting the first electrodes 11, 11, . . . and the second electrodes 12, 12, . . . to an external circuit (not shown).

The first leads 13, 13, . . . and the second leads 14, 14, . . . are arranged on the peripheral edge of the substrate 5 (i.e., on the outer side of the view area V). Specifically, the first leads 13, 13, . . . and the second leads 14, 14, . . . overlap the fringe 3 (see FIGS. 1 and 8) in a plan view seen from the operation screen 2a. That is, the first leads 13, 13, . . . and the second leads 14, 14, . . . are invisible from the operation screen 2a due to the fringe 3. In FIG. 6, the first leads 13, 13, . . . and the second leads 14, 14, . . . are not shown for the sake of simplicity.

As shown in FIGS. 4 and 8, the first leads 13 are formed on the first surface 5a of the substrate 5. One end of each first lead 13 is electrically connected to one end of one of the first electrodes 11 (i.e., an end on the left on the paper of FIG. 4). In addition, the other ends of the first leads 13, 13, . . . are collected substantially at the center in the direction along the longer sides of the substrate 5 at the peripheral edge of the first surface 5a at the bottom on the paper of FIG. 4.

The other end of each first lead 13 includes a connection pad 15 for electrically connecting to the first connector 18 of the flexible wiring board 16, which will be described later. The other end of the first lead 13 is electrically connected to the flexible wiring board 16 via the connection pad 15.

As shown in FIGS. 5 and 8, the second leads 14 are formed on the second surface 5b of the substrate 5. One end of each second lead 14 is electrically connected to one end of one of the second electrodes 12 (i.e., an end located below on the paper of FIG. 5). In addition, the other ends of the second leads 14, 14, . . . extend to be collected substantially at the center in the direction along the longer sides of the substrate 5 at the peripheral edge of the second surface 5b at the bottom on the paper of FIG. 5. The other end of each of the second leads 14, 14, . . . is spaced apart from the other end of one of the first leads 13 in the direction (the second direction d2) along the longer sides of the substrate 5.

The other end of each second lead 14 includes the connection pad 15 for electrically connecting to the second connector 19 of the flexible wiring board 16, which will be described later. The other end of the second lead 14 is electrically connected to the flexible wiring board 16 via the connection pad 15.

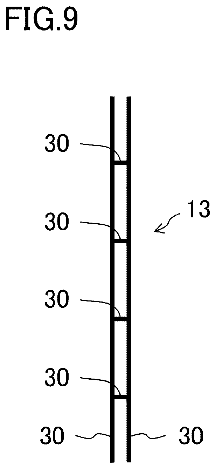

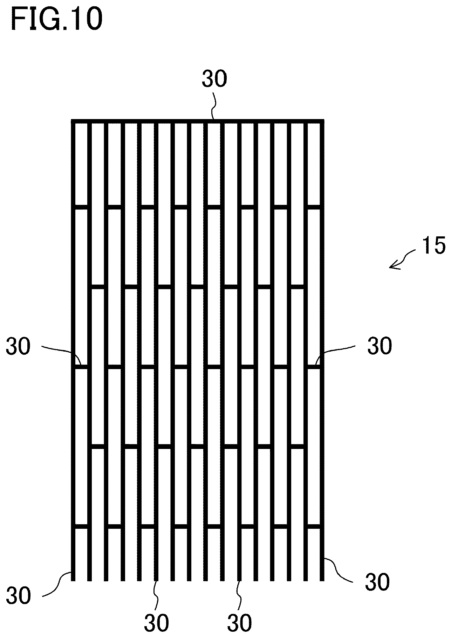

Each of the first leads 13, the second leads 14, and the connection pads 15 includes the plurality of fine lines 30, 30, . . . in a predetermined pattern on each of the first surface 5a and the second surface 5b of the substrate 5. Specifically, each of the first leads 13, the second leads 14, and the connection pads 15 includes the fine lines 30, 30, . . . in a ladder (corresponding to the second pattern described above) (see FIGS. 9 and 10). Unlike the first electrodes 11 and the second electrodes 12, each of the first leads 13, the second leads 14, and the connection pads 15 includes the fine lines 30 with a line width of 10 µm or less in one preferred embodiment.

### (Flexible Wiring Board)

As shown in FIG. 1, the touch sensor 1 includes the flexible wiring board 16. The flexible wiring board 16 has flexibility and electric properties unchanged even in a deformed state. The flexible wiring board 16 is formed of a flexible insulating film of, for example, polyimide (PI), polyethylene terephthalate (PET), or polyethylene naphthalate (PEN).

As shown in FIG. 2, the flexible wiring board 16 includes a body 17, the first connector 18, and the second connector 19. The first connector 18 and the second connector 19 are integral with the body 17 and branched off from one end of the body 17 in two directions.

As shown in FIG. 8, the first connector 18 is fixed to the peripheral edge of the first surface 5a with an anisotropic conductive adhesive (not shown), for example. In this fixed state, the first connector 18 is electrically connected to the first leads 13, 13, . . . .

The second connector 19 is fixed to the peripheral edge of the second surface 5b with the anisotropic conductive adhesive described above. In this fixed state, the second connector 19 is electrically connected to the second leads 14, 14, . . . .

### (Protective Film)

As shown in FIGS. 6 and 8, the touch sensor 1 includes a protective film 23. The protective film 23 is made of a film material for mainly protecting the second electrodes 12, 12, . . . and the second leads 14, 14, . . . . Examples of this film material include resin materials such as polyethylene terephthalate (PET), polycarbonate, cycloolefin polymer (COP), cycloolefin copolymer (COC), and PE.

The protective film 23 is substantially in a rectangular shape, for example, in a plan view and in the same size as the substrate 5. The protective film 23 is stacked to face the second surface 5b of the substrate 5. Specifically, the protective film 23 is fixed to the second surface 5b of the substrate 5 by the adhesive layer 21.

### (Fine Line)

As shown in FIGS. 11 and 12, each fine line 30 includes a conductive material buried in a groove 9. Specifically, FIG. 11 is a cross-sectional view of the fine line 30 (specifically, the fine line 30 in FIG. 7) constituting the first electrode 11 and the second electrode 12. FIG. 12 is a cross-sectional view of the fine line 30 (specifically, the fine line 30 in FIGS. 9 and 10) constituting the first lead 13, the second lead 14, and the connection pad 15. In the following description, the fine lines 30 constituting the first electrodes 11 and the second electrodes 12 may be referred to as "fine lines 30a", and the fine lines 30 constituting the first leads 13, the second leads 14, and the connection pads 15 may be referred to as "fine lines 30b". The grooves 9 in which the fine lines 30a are embedded may be referred to as "grooves (first grooves) 9a", and the grooves 9 in which the fine lines 30b are embedded may be referred to as "grooves (second grooves) 9b".

As shown in FIGS. 11 and 12, each fine line 30 includes, for example, an adhesion layer 31, a conductive layer 32, and a blackened layer 38.

The adhesion layer 31 is an element for ensuring the adhesiveness of the conductive layer 32 to the groove 9. In addition, the adhesion layer 31 functions to make the fine lines 30 less visible by the user from the operation screen 2a of the touch sensor 1.

The adhesion layer 31 contains any one of transition metals in Groups 4 to 6, Group 10, and Group 11. The adhesion layer 31 is a metal layer made of, for example, a metal nitride or a metal oxide containing at least one metal selected from the group consisting of Ti, V, W, Ta, Cr, Ag, Mo, Cu, Ni, and Nb, or a metal oxynitride containing both a metal nitride and a metal oxide. The adhesion layer 31 may be a single layer or a stack of a plurality of layers with different compositions. The adhesion layer 31 is stacked as a thin film on the groove 9 by vapor deposition or sputtering, for example.

The adhesion layer 31 includes a bottom 311 extending along the bottom of the groove 9, and a side surface 312 extending along each side surface of the groove 9. In the following description, the adhesion layer 31 of the fine line 30a may be referred to as an "adhesion layer (first metal compound layer) 31a", and the adhesion layer 31 of the fine line 30b may be referred to as an "adhesion layer (second metal compound layer) 31b". The bottom 311 of the adhesion layer 31a may be referred to as a "bottom (third layer) 311a", and each side surface 312 of the adhesion layer 31a may be referred to as a "side surface (first layer) 312a". The bottom 311 of the adhesion layer 31b may be referred to as a "bottom (third layer) 311b", and each side surface 312 of the adhesion layer 31b may be referred to as a "side surface (second layer) 312b".

The conductive layer 32 is an element for ensuring the conductivity of the fine lines 30. In this embodiment, the conductive layer 32 includes a seed layer 33 and a body layer 34. Both the seed layer 33 and the body layer 34 are made of a conductive material. Suitable as the conductive material is a conductive metal such as copper (Cu) or silver (Ag). The conductive metal may be replaced with, for example, a transparent conductive material, such as a conductive resin material, an indium tin oxide, or a tin oxide, with light-transmissive properties. In the following description, the conductive layer 32 of the fine line 30a may be referred to as a conductive layer (first conductive layer) 32a, and the conductive layer 32 of the fine line 30b may be referred to as a conductive layer (second conductive layer) 32b.

The seed layer 33 functions to improve the adhesiveness between the adhesion layer 31 and the body layer 34. Specifically, the seed layer 33 functions as a cathode for depositing a plating solution such as copper (Cu) on the adhesion layer 31, for example, in electroplating for forming the body layer 34. The seed layer 33 is stacked as a thin film on the adhesion layer 31 by vapor deposition or sputtering, for example. If the body layer 34 is formed by a method other than the electroplating, no seed layer 33 may be provided.

The body layer 34 is formed by vapor deposition, sputtering, electroless plating, or electroplating, for example. In this embodiment, the body layer 34 is stacked on the seed layer 33 by electroplating. After the electroplating, the seed layer 33 and the body layer 34 are integrally formed such that an interface between the seed layer 33 and the body layer 34 is invisible.

The blackened layer 38 functions to make the fine lines 30 less visible by the user from the operation screen 2a of the touch sensor 1. The blackened layer 38 is provided as an upper layer of each of the adhesion layer 31 and the conductive layer 32.

### (Groove)

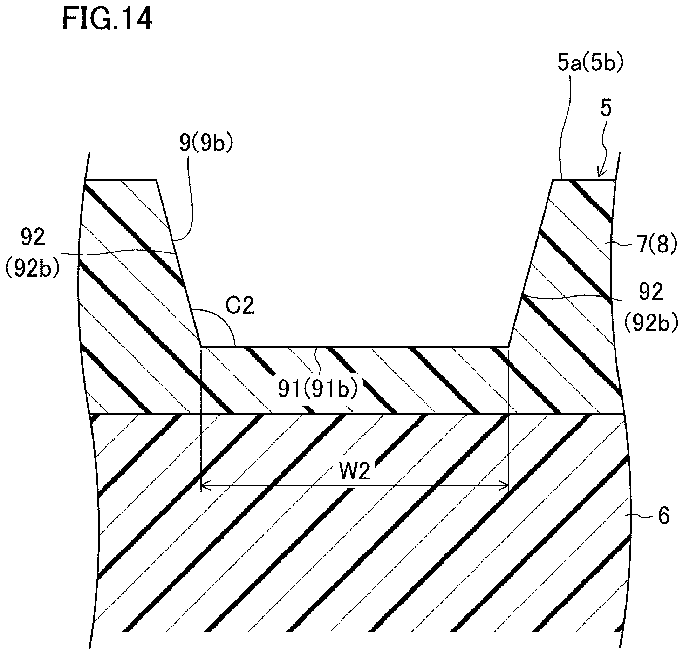

As shown in FIGS. 13 and 14, the grooves 9 are formed in the first surface 5a and the second surface 5b of the substrate 5. In the grooves 9, the fine lines 30 are embedded.

The groove 9 includes the bottom 91 extending in the width direction (i.e., the horizontal direction in the drawings) and each side surface 92 connecting the bottom 91 and the opening of the groove 9. In the following description, the bottom 91 of the groove 9a may be referred to as a "bottom (first bottom) 91a", and each side surface 92 of the groove 9a may be referred to as a "side surface (first side) 92a". The bottom 91 of the groove 9b may be referred to as a "bottom (second bottom) 91b", and each side surface 92 of the groove 9b may be referred to as a "side surface (second side) 92b".

Here, an angle (first angle) C1 represents the angle between the bottom 91a and each side surface 92a of the groove 9a, and an angle (second angle) C2 represents the angle between the bottom 91b and each side surface 92b of the groove 9b. A thickness (first thicknesses) L1 represents the thickness of each side surface 312a of the adhesion layer 31a of the fine line 30, which extends along the corresponding side surface 92a of the groove 9a. A thickness (second thicknesses) L2 represents the thickness of each side surface 312b of the adhesion layer 31b of the fine line 30, which extends along the corresponding side surface 92b of the groove 9b. In this case, the thickness L1 is smaller than the thickness L2, where the angle C1 is smaller than the angle C2.

The thickness L1 corresponds to, for example, the thickness of the adhesion layer 31a at a depth A2 from the bottom 91a of the groove 9a in the depth direction. The depth A2 is 2/3 a depth A1 which represents the depth of the groove 9a (i.e., the distance from the bottom 91a to the opening). Similarly, the thickness L2 corresponds to, for example, the thickness of the adhesion layer 31b at a depth A4 from the bottom 91b of the groove 9b in the depth direction. The depth A4 is 2/3 a depth A3 which represents the depth of the groove 9a (i.e., the distance from the bottom 91b to the opening).

The angles C1 and C2 each range from 90° to 135°. The thicknesses L1 and L2 each range from 3 nm to 150 nm.

The thickness L1 of the bottom 311a of the adhesion layer 31a of the fine line 30a and the thickness L2 of the bottom 311b of the adhesion layer 31b of the fine line 30b range from 5 nm to 150 nm.

A length (first length) W1 represents the length of the bottom 311a of the groove 9a in the width direction, and a length (second length) W2 represents the length of the bottom 311b of the groove 9b in the width direction. At this time, the length W1 is smaller than the length W2 and the angle C1 is smaller than the angle C2 in one preferred embodiment.

The ratio of a thickness T1 to the thickness L1 ranges from 1 to 1.75. The ratio of a thickness T2 to the thickness L2 ranges from 1 to 1.75.

### (Step of Forming Grooves and Fine Lines)

Next, a process of forming the grooves 9 and the fine lines 30 will be described. In the following forming process, only the grooves 9 (9a) in the first groove forming layer 7 and the fine lines 30 (30a) constituting the first electrodes 11 will be described.

First, the groove 9 is formed in the first groove forming layer 7. Next, a metal layer is formed as a thin film on the first surface 5a and the groove 9 by vapor deposition or sputtering. The metal layer is made of the metal nitride, the metal oxide, or the metal oxynitride containing both the metal nitride and the metal oxide described above. Through this film formation, the adhesion layer 31 is formed in the groove 9.

After forming the adhesion layer 31, for example, copper (Cu) is formed as a thin film on the adhesion layer 31 by vapor deposition or sputtering. Through this film formation, the seed layer 33 is formed in the groove 9.

After forming the seed layer 33, a conductive metal such as copper (Cu) is deposited on the entire area of the seed layer 33 by electroplating, for example, using the seed layer 33 as a cathode.

After a predetermined amount of copper is deposited by electroplating, the excessive copper deposited on the first surface 5a is removed. As a result, the body layer 34 is formed in the groove 9.

After forming the body layer 34, blackening is performed to form the blackened layer 38. At the end, the blackened layer 38 is subjected to rustproofing to form a rust-proof film (not shown).

Through the steps described above, the grooves 9 and the fine lines 30 are formed.

In this embodiment, the grooves 9 in the second groove forming layer 8 are formed by the same process as the grooves 9 in the first groove forming layer 7. In addition, the fine lines 30 forming each of the second electrodes 12, the first leads 13, the second leads 14, and the connection pads 15 are formed by the same process as the fine lines 30 forming the first electrodes 11.

### [Advantageous Effects of Embodiment]

As described above, the first surface 5a of a substrate 5 has the groove (i.e., the first groove) 9a and the groove (i.e., the second groove) 9b that extend linearly. The fine line 30a is embedded in the groove 9a. The fine line 30b is embedded in the groove 9b. Specifically, a conductive layer (first conductive layer) 32a made of a metal is embedded in the groove 9a with an adhesion layer (first metal compound layer) 31a interposed therebetween. The adhesion layer 31a is made of a metal compound. A conductive layer (second conductive layer) 32b made of a metal is embedded in the groove 9b with an adhesion layer (second metal compound layer) 31b interposed therebetween. The adhesion layer 31b is made of a metal compound. The groove 9a includes a bottom (first bottom) 91a, and a side surface (first side) 92a connecting the bottom 91a and the opening of the groove 9a. The groove 9b includes a bottom (second bottom) 91b, and a side surface (second side) 92b connecting the bottom 91b and the opening of the groove 9b.

Here, an angle (first angle) C1 represents the angle between the bottom 91a and each side surface 92a of the groove 9a, and an angle (second angle) C2 represents the angle between the bottom 91b and each side surface 92b of the groove 9b. A thickness (first thicknesses) L1 represents the thickness of the side surface 312b of the adhesion layer 31 of the fine line 30a, which extends along the side surface 92a of the groove 9a. A thickness (second thicknesses) L2 represents the thickness of the side surface 312b of the adhesion layer 31 of the fine line 30b, which extends along the side surface 92b of the groove 9b. In this case, the thickness L1 is smaller than the thickness L2, where the angle C1 is smaller than the angle C2.

As described above, the fine lines 30a and 30b each include the conductive layer 32 made of a metal and the adhesion layer 31 made of a metal compound. The conductive layer 32 is embedded in the groove 9 with the adhesion layer 31 interposed therebetween, which is formed in the shape of a thin film on the groove 9. This adhesion layer 31 ensures the adhesion of the conductive layer 32 to the groove 9.

However, for example, when electricity flows into the conductive layer 32, heat is applied to the conductive layer 32 and the adhesion layer 31, which may increase the temperatures in the conductive layer 32 and the adhesion layer 31. If the conductive layer 32 is made of a metal, the adhesion layer 31 is made of a metal compound, and the temperatures in the conductive layer 32 and the adhesion layer 31 rise, the conductive layer 32 expands more, that is, has a larger volume than the adhesion layer 31. For example, Cu has a coefficient of linear expansion of 17.7 × 10⁻⁶K, while ceramics (metal nitride) has a coefficient of linear expansion ranging from 1 to 10 × 10⁻⁶K. Accordingly, the expanding conductive layer 32 presses the adhesion layer 31. In particular, if the groove is recessed and bottomed, both the side surfaces 312 of the groove 9 face each other, which presses the adhesion layer 31 (specifically, the side surfaces 312 of the adhesion layer 31) extending along the side surfaces of the groove 9.

In addition, if the adhesion layer 31 is made of a metal compound, the larger the film thickness of the adhesion layer 31, the higher the rigidity of the adhesion layer 31 and the more stress against the expansion of the conductive layer 32 is likely to occur inside the conductive layer 32, which leads to a damage of the adhesion layer 31.

More specifically, the stress in the depth direction of the groove 9 (the vertical direction in FIGS. 11 and 12) generated by the expanding conductive layer 32 is applied to the bottom 311 of the adhesion layer 31. The stress in the width direction of the groove 9 (the horizontal direction in FIGS. 11 and 12) is applied to the side surface 312 of the adhesion layer 31. At this time, since the groove 9 has the opening to be opposed to the bottom 311 of the adhesion layer 31, the stress applied to the bottom 311 of the adhesion layer 31 does not increase, and thus the adhesion layer 31 is less likely to be damaged. In contrast, since the side surfaces 312 of the adhesion layer 31 are formed on the side surfaces 92 on both sides of the groove 9, stress in the width direction of the groove 9 is applied. In particular, with a decrease in the angle between the bottom 91 and the side surface 92 of the groove 9, the angle between the stress in the width direction of the groove 9 and the side surface 92 (the side surface 312 of the adhesion layer 31) becomes almost the right angle. This increases the influence of the stress due to the expanding conductive layer 32 on the adhesion layer 31.

In this embodiment, the thickness of the side surface 312 of the adhesion layer 31 extending along the side surface 92 of the groove 9 changes in accordance with the angle between the bottom 91 and the side surface 92 of the groove 9. Specifically, in the groove 9a having a smaller angle C1 between the bottom 91a and the side surface 92a, the side surface 312b of the adhesion layer 31a of the fine line 30a has a smaller thickness L1. With a decrease in the thickness L1 in accordance with the angle C1, the side surface 312 of the adhesion layer 31 can be easily warped, which can reduce the influence of the stress caused by the expanding conductive layer 32. This can reduce the damage of the adhesion layer 31. This can provide a conductive film resistant to disturbance, such as a temperature change or erosion.

The angles C1 and C2 range from 90° to 135°. The thicknesses L1 and L2 range from 3 nm to 150 nm. Accordingly, the smaller thickness of the adhesion layer 31 can reduce the concentration of stress on the corners of the adhesion layer 31 and reduce deterioration in the adhesion of the adhesion layer 31 to the groove 9.

The adhesion layer 31 contains at least one transition metal selected from transition metals of Groups 4 to 6, Group 10, and Group 11. This improves the chemical resistance of the adhesion layer 31 and makes the adhesion layer 31 less visible from the outside.

The adhesion layer 31 contains nitrogen in one particularly preferred embodiment. Since the nitridation of the adhesion layer 31 can reduce the reflectance of the adhesion layer 31, the adhesion layer 31 becomes less visible from the outside.

The adhesion layer 31a includes a bottom (third layer) 311a along the bottom 91a of the groove 9a. The thickness T1 of the bottom 311a ranges from 5 nm to 150 nm. Accordingly, the adhesion layer 31a becomes less visible from the outside.

The length (first length) W1 of the groove 9a in the width direction is smaller than the length (second length) W2 in the width direction of the groove 9b and the angle C1 is smaller than the angle C2 in one preferred embodiment. A smaller length of the groove 9 in the width direction can reduce the visibility of the adhesion layer 31 but also reduces the adhesion between the adhesion layer 31 and the groove 9. With a decrease in the angle between the bottom and the side surface of the groove 9, the thickness of the side surface 312 of the adhesion layer 31 can decrease, which can improve the adhesion between the adhesion layer 31 and the groove 9.

The ratio of the thickness (third thickness) T1 to the thickness L1 ranges from 1 to 1.75. This can reduce excessive film stress on the adhesion layer 31.

### [Other Embodiments]

While the first direction d1 and the second direction d2 are defined as shown in FIGS. 1 to 5 in the embodiment described above, the directions are not limited thereto. For example, the first direction d1 may extend from the left to the right on the paper, whereas the second direction d2 may extend from the bottom to the top on the paper. That is, each first electrode 11 may extend along the longer sides of the substrate 5, whereas each second electrode 12 may extend along the shorter sides of the substrate 5.

While the single substrate 5 is used in the embodiment described above, the configuration is not limited thereto. For example, the substrate 5 may be a multilayer obtained by bonding two bases.

While the electrodes (i.e., the first electrodes 11 and the second electrodes 12) are formed on both surfaces (i.e., the first surface 5a and the second surface 5b) of the single substrate 5 in the embodiment described above, the configuration is not limited thereto. Specifically, the first electrodes 11 and the second electrodes 12 may be formed on only one surface (i.e., any one of the first surface 5a and the second surface 5b) of the single substrate 5.

While the rectangular view area V is employed in the embodiment described above, the configuration is not limited thereto. The view area V may be substantially in a circular shape, for example.

While each of the first electrodes 11 and the second electrodes 12 is in a band shape in the embodiment described above, the configuration is not limited thereto. For example, an intermediate portion of each second electrode 12 may protrude to taper in the second direction d2 or the opposite direction into protrusions (not shown) repeated in the extending direction. Similarly, each first electrode 11 may have the following shape in place of the band shape described above. An intermediate portion may protrude to taper in the first direction d1 or the opposite direction into protrusions (not shown) repeated in the extending direction. In other words, each electrode may be formed into a shape with pads in a rhombic shape, for example, repeated in the extending direction.

In this embodiment, the corner between the bottom 91 and the side surface 92 of each groove 9 is filleted. The side surface 92 of the groove 9 may be inclined so as to gradually expand from the bottom 91 of the groove 9 toward the opening.

In this embodiment, at least one of the bottom 91 and the side surface 92 of the groove 9 may have an arc-shaped cross section. In this case, the angle C1 is formed between a tangent line at the deepest of the bottom 91a and a tangent line of the side surface 92a (e.g., a tangent line at the depth A2 in FIG. 11) in the groove 9a. The angle C2 may be formed between a tangent line at the deepest of the bottom 91b and a tangent line of the side surface 92b (e.g., a tangent line at the depth A4 in FIG. 12) in the groove 9b.

An example has been described in this embodiment where the groove 9 includes the groove 9a and the groove 9b. The groove 9a has the angle C1 between the bottom 91a and the side surface 92a. The groove 9b has the angle C2 between the bottom 91b and the side surface 92b. That is, an example has been described in this embodiment where the groove 9 includes two types of grooves having different angles between the bottom and the side surface, the configuration is not limited thereto. For example, the groove 9 may include three or more types of grooves having different angles between the bottom and the side surface.

In this embodiment, the blackened layer 38 may be omitted.

An example has bee described above in the embodiment where the conductive film 4 according to the embodiment of the present disclosure is applied to the touch sensor 1, but the application is not limited thereto. For example, the conductive film 4 according to the embodiment of the present disclosure can be widely applied to technical fields other than the touch sensor 1 (e.g., various technical fields such as a liquid crystal display device, an organic electroluminescent display device (OLED), a micro LED display device, a solar cell device, a heater device, an antenna device, and an electromagnetic wave shielding sheet).

While the embodiment of the present disclosure have been described above, the present disclosure is not limited thereto and various modifications can be made within the scope of the present disclosure.

### INDUSTRIAL APPLICABILITY

The present disclosure is industrially applicable as a conductive film applicable to a touch sensor or the like.

### DESCRIPTION OF REFERENCE CHARACTERS

- 1: Touch Sensor
- 2: Cover Member
- 3: Fringe
- 4: Operation Screen
- 5: Substrate
- 5a: First Surface
- 5b: Second Surface
- 6: Film Base
- 7: First Groove Forming Layer
- 8: Second Groove Forming Layer
- 9: Groove
- 9a: Groove (First Groove)
- 9b: Groove (Second Groove)
- 91: Bottom
- 91a: Bottom (First Bottom)
- 91b: Bottom (Second Bottom)
- 92: Side Surface
- 92a: Side Surface (First Side)
- 92b: Side Surface (First Side)
- 11: First Electrode
- 12: Second Electrode
- 13: First Lead
- 14: Second Lead
- 15: Connection Pad
- 16: Flexible Wiring Board
- 17: Body
- 18: First Connector
- 19: Second Connector
- 21: Adhesive Layer
- 22: Cutout
- 23: Protective Film
- 30: Fine Line
- 30a: Fine Line
- 30b: Fine Line
- 31: Adhesion Layer
- 31a: Adhesion Layer (First Metal Compound Layer)
- 31b: Adhesion Layer (Second Metal Compound Layer)
- 311: Bottom
- 311a: Bottom (Third Layer)
- 312a: Bottom
- 312: Side Surface
- 312a: Side Surface (First Layer)
- 312b: Side Surface (Second Layer)
- 32: Conductive Layer
- 32a: Conductive Layer (First Conductive Layer)
- 32b: Conductive Layer (Second Conductive Layer)
- 33: Seed Layer
- 34: Body Layer
- 38: Blackened Layer
- V: View Area
- C1: Angle (First Angle)
- C2: Angle (Second Angle)
- L1: Thickness (First Thickness)
- L2: Thickness (Second Thickness)
- T1: Thickness (Third Thickness)
- T2: Thickness
- W1: Length (First Length)
- W2: Length (Second Length)

## Claims

1. A conductive film comprising:
a substrate with a first surface, the first surface of the substrate including a first groove and a second groove that are bottomed and extend linearly,
a first conductive layer made of a metal being embedded in the first groove with a first metal compound layer interposed therebetween, the first metal compound layer being made of a metal compound; and
a second conductive layer made of a metal being embedded in the second groove with a second metal compound layer interposed therebetween, the second metal compound layer being made of a metal compound;
wherein, the first groove including a first bottom, and a first side connecting the first bottom and an opening of the first groove,
the second groove including a second bottom, and a second side connecting the second bottom and an opening of the second groove,
the first metal compound layer including a first layer along the first side,
the second metal compound layer including a second layer along the second side,
a first thickness of the first layer being smaller than a second thickness of the second layer, where a first angle between the first bottom and the first side is smaller than a second angle between the second bottom and the second side.

2. The conductive film of claim 1, wherein
the first angle ranges from 90° to 135°, and
the first thickness ranges from 3 nm to 150 nm.

3. The conductive film of claim 1, wherein
the first metal compound layer contains at least one transition metal selected from transition metals of Groups 4 to 6, Group 10, and Group 11.

4. The conductive film of claim 1, wherein
the first metal compound layer contains nitrogen.

5. The conductive film of claim 1, wherein
the first metal compound layer includes a third layer along the first bottom, and
the third layer has a thickness ranging from 5 nm to 150 nm.

6. The conductive film of claim 1, wherein
the first angle is smaller than the second angle, where a first length of the first groove in a width direction is smaller than a second length of the second groove in the width direction.

7. The conductive film of claim 1, wherein
the first metal compound layer includes a third layer along the first bottom, and
T1/L1 ranges from 1 to 1.75, where T1 is a first thickness and L1 is a third thickness that is a thickness of the third layer.
